# EUROPEAN PATENT SPECIFICATION

(11) **EP 1 611 675 B1**
(45) Date of publication and mention of the grant of the patent: **18.11.2009**
(21) Application number: 04720015.9
(22) Date of filing: 12.03.2004
(51) Int. Cl.: H03F 1/02, H03F 1/32

(54) **POWER AMPLIFIER AND A RF TRANSMITTER AND TERMINAL INCLUDING THE AMPLIFIER**
LEISTUNGSVERSTÄRKER UND HOCHFREQUENZSENDER UND MOBILSTATION, DIE DEN VERSTÄRKER BEINHALTET
AMPLIFICATEUR DE PUISSANCE ET EMETTEUR RADIOELECTRIQUE ET TERMINAL PRESENTANT LEDIT AMPLIFICATEUR

(30) Priority: 31.03.2003 GB 0307368
(43) Date of publication of application: 04.01.2006
(73) Proprietor: MOTOROLA, INC., Schaumburg, IL 60196 (US)
(72) Inventor: PURSCHKE, Hagen Roger, 16567 Schoenfliess (DE)
(74) Representative: McCormack, Derek James
(86) International application number: PCT/EP2004/050302
(87) International publication number: WO 2004/088836

(56) References cited:
- GB-A- 2 321 574
- US-A- 5 193 223
- US-A- 5 287 555
- US-A- 5 426 641
- US-A- 5 732 334
- US-B1- 6 351 189

## Description

### Field of the invention

The present invention relates to a power amplifier and an RF transmitter and terminal including the amplifier. The transmitter and terminal, e.g. mobile station (which may incorporate the transmitted), may be for use in a mobile radio communications network.

### Background of the invention

Portable and mobile radio communication terminals in use in a mobile communication system are often arranged to communicate with one another through a fixed system infrastructure including amongst other things one or more base (transceiver) stations. The terminals and the infrastructure are often collectively referred to as a trunked radio system. Examples of such systems are TETRA systems operating in accordance with the TETRA standard operating protocols defined by European Telecommunications Institute (ETSI) and APCO systems operating in accordance with standards defined by the US Telecommunication. Industry. Association (TIA) (see e.g. G.B 2321574).

The coverage area of a trunked radio communication system is often divided into cells. Each cell is a region served by a particular base (transceiver) station. Several base stations may be linked together to form a network. A mobile station may communicate with another mobile station in the same cell via the serving base station, or in a different cell via the serving base station and the network.

Henceforth the mobile station (MS) will be used to describe a portable or mobile radio terminal that is capable of communication via a trunked or cellular communication system (and possibly also in a direct mode with other MSs). Thus, the term mobile station (MS) will cover portable or mobile radio terminals, portable or mobile radio telephones, 3G or 4G mobile communication devices, wirelessly linked lap-top computers, wirelessly linked personal digital assistants (PDA) and the like.

TETRA systems employ a π/4 DQPSK (differential quadrature phase shift keying) modulation procedure as is well known in the art. One feature of this particular procedure is the non-constant envelope of the RF carrier signal it produces. This requires the use of linear components in order to prevent disturbances due to intermodulations from being transmitted in neighbouring channels. Accurate biasing of the transmitter RF power amplifier is required. This is in order to keep the active device, e.g. transistor, used in the powder amplifier circuit in a linear region of its transfer characteristic, and thereby meet the requirements for a linear transmitter design as defined in the TETRA operating standard.

In prior art linear transmitter designs, it is known to use feedback control circuits which operate by sampling the DC current of a power amplifier continuously during transmission. The DC current is sampled by a voltage drop across a resistor, e.g. in a collector or drain DC path of the amplifier active device. The measured value is then compared with a constant reference value. A control element, e.g. a further transistor or operational amplifier, continuously adjusts the bias voltage of the amplifier device in a manner such that the remaining error following the comparison is adjusted toward zero.

Where an amplifier circuit operates in this known way, a significant problem arises where the amplifier is for use in a linear transmitter in a terminal such as a MS for use in a mobile communication system such as a TETRA system. As noted earlier, the RF carrier in such a system has a non-constant envelope. This causes the sampled current to vary in accordance with the variation of applied amplitude envelope of the RF carrier signal. Hence no stable amplifier bias current control is possible. Furthermore, the modulated signal becomes distorted, especially when the lowest modulating frequency is close to 0Hz.

In prior art arrangements, digital settings are known which use look-up tables for making the DC biasing. Generally, these tables allow the bias voltage versus temperature characteristic of the amplifier active device to be regulated using a measurement of temperature with a temperature sensor. A disadvantage of this procedure is that these characteristics do not represent the particular behaviour of an individual component. Instead, they represent only a general average performance of the components. Batch-to-batch variations will cause a deviation from the performance defined in the look up table. An example for an amplifier for TDMA wireless communication systems which comprises adjusting the amplifier bias level outside of burst intervals is given in US 5 426 641.

### Summary of the Invention

According to the present invention in a first aspect there is provided an RF power amplifier circuit for use in an RF communication station operable in a RP communication system using a time slot signalling procedure, the amplifier circuit comprising:
(a) an RF power amplifier;
(b) a measurement circuit for deriving a bias voltage for adjusting a bias of the RF power amplifier; and characterised by:
(c) control means for activating the measurement circuit at one or more pre-defined slots in the time slot signalling procedure.

The amplifier circuit may be for use in a transmitter of a mobile station operable in a mobile communication system. Such a mobile station may include a receiver operable to detect signals from a swerving base transceiver of the system. The transmitter and receiver of the mobile station may comprise a transceiver having some common components. Such a base transceiver may be part of the infrastructure of the system.

The control means of the amplifier circuit according to the first aspect may include timing means operable to indicate time slots in the time slot signalling procedure reserved for transmission of control signals. In particular, the time slot may be one which is reserved for operation of a training algorithm. It is important that a time slot is available where no modulation occurs. The absence of modulation makes accurate operation of the control means possible. For example, the TDMA (time divided multiple access) signalling protocol used in a mobile communication system operating according to TERRA standards includes in a particular frame of its multiframe timing procedure a time slot devoted to transceiver training and such a slot is modulation free. This is explained further later.

The timing means may be operable to activate the measurement circuit when such a slot is detected. In the TETRA standard, the training slot represents a half slot, i.e. half of a normal slot. Within that half slot amplifier phase training occurs for only 1ms. So DC bias control by the invention may be applied at any time of such a training half slot except during any time the training or so called 'squiggle' signal is applied for amplifier phase training.

The timing means may include a clock of a RP terminal in which the amplifier circuit is incorporated. Where such a clock is in a MS, such a clock may be sychronised with respect to a system clock in infrastructure of the communication system. Alternatively, the timing means may include a processor operable to detect receipt of a control signal from a remote transmitter in which timing of said time slots is indicated. For example, the amplifier circuit may be for use in a mobile station which includes a receiver operable to detect said control signal from a base transceiver of the system sent in the specified time slots.

The control means may be operable to activate the measurement circuit in response detection of the appropriate time slots, e.g. by detection of the start of a received control signal and to de-activate the measurement circuit for periods between such time slots by detection of the end of the control signal.

In the amplifier circuit according to the first aspect of the invention the measurement circuit may comprise a feedback control loop which is operable to derive an error control signal to provide bias adjustment of the power amplifier.

The amplifier circuit may include a detector for measuring an electrical property of an output from the power amplifier, e.g. the current through a resistor included in an output circuit, and a feedback loop including a comparator for comparing an output of the detector with a predetermined reference value to produce an error control signal. The feedback loop may include, coupled to an output of the comparator, a processor which is operable to apply an algorithm to detect when an output of the comparator indicates minimum deviation of the output of the detector from a predetermined reference value. The processor may comprise a digital signal processor and the feedback loop may include, coupled to the output of the processor, a digital-to-analog converter.

The said processor may comprise a successive approximation register. The comparator may have an output' feeding the comparison result produced thereby selectively to the increment or decrement inputs of the successive approximation register. The output of the successive approximation register may be a digital signal which indicates a change in the amplifier bias needed to adjust the comparator output signal to a minimum. The successive approximation register may be connected to the input of a digital-to-analogue converter. The digital-to-analogue converter may be connected to produce from the digital output of the successive approximation register a bias voltage which is applied to adjust the potential at a control electrode of the power amplifier.

The amplifier circuit according to the first aspect of the invention may comprise an amplifying device which comprises a solid state amplifying device such as a transistor which may be in bipolar form or in field effect (JFET or MOSFET) form. For example, where a MOSFET (metal oxide semiconductor field effect transistor) is employed, the input signal to be amplified may be applied at a gate electrode of the transistor. The output signal from the transistor may for example be extracted from the drain electrode. Where the transistor is in the form of a bipolar junction transistor, the input signal may applied at the base of the transistor and the output signal may be extracted from the collector of the transistor.

The amplifier circuit according to the first aspect may include two or more amplifying devices. Such devices may be mutually connected in a parallel or a series configuration in a known manner to give a greater output for a given input.

The amplifier circuit according to the first aspect of the present invention may find use in RF circuits for a wide number of applications in digital applications in which time slotted transmission protocols are used. Such applications include transmitters for RF communications, RF smartcards, RF near field excitation devices, radio and television broadcasting and many others. In this specification, 'RF' is generally understood to mean frequencies of greater than 10KHz, e.g. up to 500GHz. In many cases the RF energy produced in the application will have a frequency of from 100KHz to 100GHz.

Where the invention is employed in RF communications transmitters, such transmitters may be incorporated in communications apparatus. For example, the apparatus may, as noted earlier, comprise a mobile station or alternatively a fixed radio station such as a base transceiver station which provides communications to or from MSs in a mobile communications system.

According to the present invention in a second aspect there is provided an RF transmitter including an amplifier circuit according to the first aspect.

According to the present invention in a third aspect there is provided a terminal for use in a RF communication system, the terminal including a transmitter according to the second aspect. The terminal may comprise a fixed or mobile station for use in a mobile communication system. The system may be one which operates according to TETRA standard procedures.

The invention beneficially provides an amplifier circuit suitable for use in a linear transmitter which does not suffer from the problems of the prior art described earlier. The invention provides in a simple manner an accurate amplifier bias control mechanism which is not affected by batch-to-batch variations in the active device of the amplifier. Furthermore, the bias setting is carried out during time slots when the RF carrier signal amplitude envelope is not varying and so avoids the bias control instability and signal distortion of prior art arrangements described earlier.

Embodiments of the present invention will now be described by way of example with reference to the accompanying drawings, in which:

### Brief description of the drawings

FIG. 1 is a schematic circuit diagram of an RF power amplifier circuit embodying the invention.
FIG. 2 is a schematic block circuit diagram of a an RF transceiver incorporating the amplifier circuit shown in FIG. 1.

### Detailed description of an embodiment of the invention

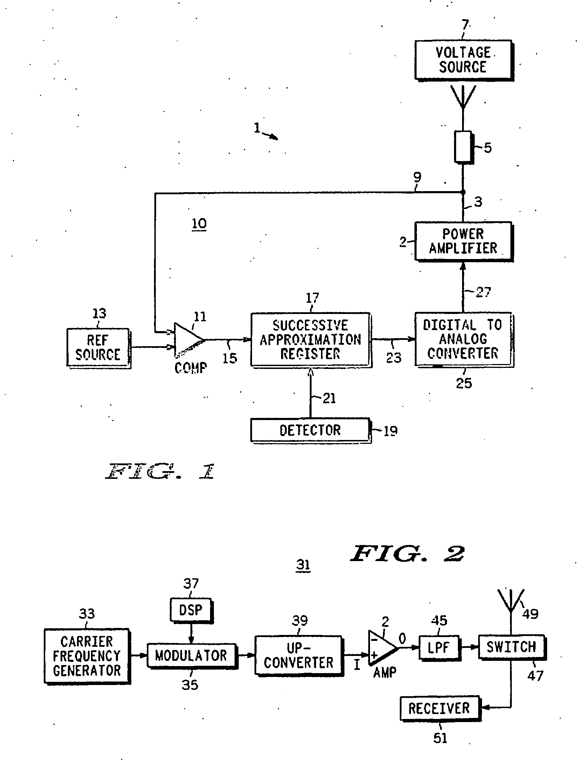

FIG. 1 shows an RF power amplifier circuit 1 embodying the present invention. The circuit 1 includes an RF power amplifier 2 included in a linear transmitter for use in a TETRA mobile station in the manner illustrated later with reference to FIG. 2. The amplifier 2 is connected at an electrode 3 (e.g. a source or drain electrode where the amplifier comprises a MOSFET device) via a test resistor 5 to a DC supply voltage source 7. The current flowing through the test resistor 5 is sampled by a connection 9 leading from the junction between the electrode 3 and the resistor 5 to a feedback loop 10.

A signal representing the value of the sampled current is applied as one input to a comparator 11 having also a reference input from a reference source 13. The comparator 11 produces an output 15 which is a measure of the difference or error between the sampled current value and the reference. This output 15 is applied to a successive approximation register 17. The register 17 is controlled via an input 21 by activation and de-activation signals from a detector 19. The register 17 is connected at its output 23 to a digital-to-analogue converter 25 producing a bias voltage output which is applied at a connection 27 to adjust the control bias voltage of the amplifier 3. The DC current of the amplifier 2 changes according to that bias voltage (and is determined also by the voltage applied across the test resistor 5).

The circuit 1 operates by measurement of the current through the test resistor 5 in a manner similar to that used in the prior art. The difference between the measured current and the reference provided by the source 13 is also measured by the comparator 11 in a manner similar to the prior art. However, the remainder of the DC bias control mechanism as provided by the register 17 and the converter 25 in the circuit shown in FIG. 1 is switched on only when the detector 19 indicates synchronisation with the second half of a CLCH slot after training has occurred in the first half of the slot in the slot timing structure of the TETRA operating protocol.

This is explained further as follows. In the TETRA operating protocol, transmissions to and from mobile stations are controlled in a time slot mode. The slot duration for a traffic (voice, data etc) channel is 14.167ms. Four slots represent four physical channels in a TDMA (time division multiple access) protocol and form one frame of duration 56.67ms in an 18 frame multiframe structure. 17 frames of each frame of this repeating frame structure are used for "normal" traffic (i.e. voice or data transmision) and the other, the 18th frame, is reserved for control signalling Half of a slot (e.g. slot no.1) in the 18th control signalling frame is used for operation of training algorithms. The slot in which this occurs is known as the CLCH (Common Linearization CHannel). By the embodiment of the invention described with reference to FIG. 1, the bias control mechanism of the amplifier 2 is switched on when synchronization with the CLCH is detected by the detector 19. The register 17 is activated by the control signal from the detector 19 indicating this condition and the error signal obtained in the output 15 from the comparator 11 is adjusted to zero by successively adjusting the output from the register 17 to the digital-to-analog converter 25 thereby adjusting the DC bias applied at the connection 27. When the end of the CLCH slot is detected, the output from the register 17 is set to a constant value, thereby setting the bias of the amplifier 2 for the next following 17 frames. The' bias is re-adjusted when the register is re-activated by the detector indicating synchronizing with the CLCH of the next 18th frame.

It is assumed in use of this procedure that drifts of required bias of the amplifier 2 with temperature is a long term effect and that the required bias to be applied is essentially stable between two adjacent CLCHs.

The advantage of operating in this way is that the π/4 DQPSK modulation which causes a varying RF carrier signal envelope present during frames 1 to 17 of the TETRA timing structure is not present during the CLCH slow, so no disturbance of the DC current sampling of the current through the test resistor 5 is caused during that slot.

In Figure 2, a transceiver 31 for use in a mobile station of a mobile communications system is shown. A carrier frequency generator 33 produces a baseband carrier frequency signal which is applied to a modulator 35. The baseband carrier frequency signal is modulated in the modulator 35 by applying thereto digital data from a DSP (digital signal processor) 37. The modulated output from the modulator 35 is applied to an upconverter 39 which converts the modulated baseband signal to a modulated RF signal. The modulated RF signal is applied as an input signal I to the power amplifier 2 as described earlier. An amplified output signal O is produced by the amplifier 2 and is filtered by a LPF (low pass filter) 45 which extracts from the output signal O harmonics other than the first harmonic. The amplified and filtered output signal from the amplifier 2 is delivered via a switch or circulator 47 to an antenna 49 which transmits the signal over the air as a RF signal to a remote receiver (not shown). Incoming RF signals may be received by the antenna 49 and diverted by the switch 47 to be processed by a receiver 51 in a known manner. Operation of the amplifier 2 in the manner described earlier with reference to FIG. 1 provides substantially linear operation of the transmitter section of the transceiver 31.

## Claims

1. An RF power amplifier circuit (1) for use in an RF communication station operable in a RF communication system using a time slot signalling procedure, the amplifier circuit comprising:
(a) an RF power amplifier (2);
(b) a measurement circuit (5,9,10,11,17,25) for deriving a bias voltage for adjusting a bias of the RF power amplifier; and
(c) control means (19) for activating the measurement circuit at one or more pre-defined slots in the time slot signalling procedure, wherein the control means includes timing means operable to indicate time slots in the time slot signalling procedure reserved for control signalling and the control means is operable to activate the measurement circuit in response detection of such time slots and to de-activate the measurement circuit for periods between such time slots, wherein the timing means is operable to detect receipt of a control signal from a remote transmitter in which timing of said time slots is indicated.

2. An amplifier circuit according to claim 1 which is for use in a transmitter of a mobile station operable in a mobile communication system and the mobile station includes a receiver operable to detect said control signal from a base transceiver of the system.

3. An amplifier circuit according to any one of the preceding claims wherein the measurement circuit comprises a feedback control loop which is operable to derive an error control signal to provide bias adjustment of the power amplifier.

4. An amplifier circuit according to claim 3 wherein the circuit includes a detector for measuring an electrical property of an output from the power amplifier and a feedback loop including a comparator for comparing an output of the detector with a predetermined reference value to produce an error control signal.

5. An amplifier circuit according to claim 4 wherein the feedback loop includes, coupled to an output of the comparator, a processor which is operable to apply an algorithm to calculate from the error control signal from the comparator an amplifier bias adjustment required to give a minimum error signal output from the comparator.

6. An amplifier circuit according to claim 5 wherein the processor comprises a digital signal processor and the feedback loop includes, coupled to the output of the processor, a digital-to-analog converter.

7. An amplifier circuit according to claim 5 or claim 6 wherein the processor comprises a successive approximation register.

8. An amplifier circuit according to any one of claims 5 to 7 wherein the control means is operable to activate the measurement circuit in response to detection of predetermined time slots and to de-activate the measurement circuit for periods between such time slots, and the processor is operable to provide a constant output during periods of de-activation of the measurement circuit.

9. An RF transmitter (31) including an amplifier circuit according to any one of the preceding claims.

10. A terminal for use in a RF communication system, the terminal including a transmitter according to claim 9 and a receiver for receiving RF signals including the control signal.

11. A terminal according to claim 10 and which comprise a mobile station for use in a mobile communication system.

12. A terminal according to claim 10 or claim 11 and which is operable according to TETRA standard procedures.

## Patentansprüche

1. Ein HF-Leistungsverstärkerkreis (1) zur Verwendung in einer HF-Kommunikationsstation, die in einem HF-Kommunikationssystem betreibbar ist und eine Zeitschlitzsignalisierungsprozedur benutzt, wobei der Verstärkerkreis umfasst:
(a) einen HF-Leistungsverstärker (2);
(b) einen Messkreis (5,9,10,11,17,25) zum Gewinnen einer Gleichspannung zum Einstellen einer Vorspannung des HF-Leistungsverstärkers; und
(c) ein Steuerungsmittel (19) zum Aktivieren des Messkreises bei einem oder mehreren vordefinierten Schlitzen in der Zeitschlitzsignalisierungsprozedur, wobei das Steuerungsmittel ein Zeiteinteilungsmittel einschließt, das betreibbar ist, um in der Zeitschlitzsignalisierungsprozedur Zeitschlitze anzuzeigen, die für Steuerungssignalisierung reserviert sind und wobei das Steuerungsmittel betreibbar ist, um den Messkreis in Reaktion auf eine Erkennung solcher Zeitschlitze zu aktivieren und den Messkreis für Zeiträume zwischen solchen Zeitschlitzen zu deaktivieren, wobei das Zeiteinteilungsmittel betreibbar ist, um einen Empfang eines Steuerungssignals von einem fernen Sender zu erkennen, in welchem eine Zeiteinteilung der Zeitschlitze angezeigt wird.

2. Ein Verstärkerkreis gemäß Anspruch 1, der zur Verwendung in einem Sender einer Mobilstation in einem Mobilkommunikationssystem betreibbar ist, und wobei die Mobilstation einen Empfänger einschließt, der betreibbar ist, um das Steuerungssignal von einem Basis-Senderempfänger des Systems zu erkennen.

3. Ein Verstärkerkreis gemäß irgendeinem der vorhergehenden Ansprüche, wobei der Messkreis eine rückgekoppelte Steuerungsschleife umfasst, die betreibbar ist, um ein Fehlersteuerungssignal zu gewinnen, um eine Vorspannungseinstellung für den Leistungsverstärker bereitzustellen.

4. Ein Verstärkerkreis gemäß Anspruch 3, wobei der Kreis einschließt: einen Detektor zum Messen einer elektrischen Eigenschaft einer Ausgabe aus dem Leistungsverstärker und eine Rückkopplungsschleife, die einen Vergleicher zum Vergleichen einer Ausgabe des Detektors mit einem vorbestimmten Bezugswert einschließt, um ein Fehlersteuerungssignal zu erzeugen.

5. Ein Verstärkerkreis gemäß Anspruch 4, wobei die Rückkopplungsschleife einen Prozessor einschließt, der mit einer Ausgabe des Vergleichers verbunden ist und betreibbar ist, um einen Algorithmus anzuwenden, um aus dem Fehlersteuerungssignal von dem Vergleicher eine Verstärkervorspannungseinstellung zu berechnen, die benötigt wird, damit sich eine minimale Fehlersignalausgabe aus dem Vergleicher ergibt.

6. Ein Verstärkerkreis gemäß Anspruch 5, wobei der Prozessor einen Digitalsignalprozessor umfasst und die Rückkoppelungsschleife einen Digital-zu-Analog-Wandler einschließt, der mit der Ausgabe des Prozessors verbunden ist.

7. Ein Verstärkerkreis gemäß Anspruch 5 oder 6, wobei der Prozessor ein Verzeichnis zur schrittweisen Näherung umfasst.

8. Ein Verstärkerkreis gemäß irgendeinem der Ansprüche 5 bis 7, wobei das Steuerungsmittel betreibbar ist, um den Messkreis in Reaktion auf eine Erkennung von vorbestimmten Zeitschlitzen zu aktivieren und den Messkreis für Zeiträume zwischen solchen Zeitschlitzen zu deaktivieren, und wobei der Prozessor betreibbar ist, um eine gleichbleibende Ausgabe während Zeiträumen einer Deaktivierung des Messkreises bereitzustellen.

9. Ein HF-Sender (31), der einen Verstärkerkreis gemäß irgendeinem der vorhergehenden Ansprüche einschließt.

10. Ein Endgerät zur Verwendung in einem HF-Kommunikationssystem, wobei das Endgerät einen Sender gemäß Anspruch 9 und einen Empfänger zum Empfang von HF-Signalen einschließlich des Steuerungssignals einschließt.

11. Ein Endgerät gemäß Anspruch 10, das eine Mobilstation zur Verwendung in einem Mobilkommunikationssystem umfasst.

12. Ein Endgerät gemäß Anspruch 10 oder 11, das gemäß TETRA-Standardprozeduren betreibbar ist.

## Revendications

1. Circuit amplificateur de puissance RF (1) à utiliser dans une station de communication RF pouvant fonctionner dans un système de communication RF utilisant une procédure de signalement d'intervalle de temps, le circuit amplificateur comprenant :
(a) un amplificateur de puissance RF (2) ;
(b) un circuit de mesure (5, 9, 10, 11, 17, 25) destiné à dériver une tension de polarisation pour régler une polarisation de l'amplificateur de puissance RF ; et
(c) un moyen de commande (19) destiné à activer le circuit de mesure à un ou plusieurs intervalles prédéfinis dans la procédure de signalement d'intervalle de temps, le moyen de commande comprenant un moyen de programmation permettant d'indiquer les intervalles de temps de la procédure de signalement d'intervalle de temps réservés au signalement de commande et le moyen de commande permettant d'activer le circuit de mesure en réponse à la détection de tels intervalles de temps et de désactiver le circuit de mesure pendant les périodes situées entre de tels intervalles de temps, le moyen de programmation permettant de détecter la réception d'un signal de commande provenant d'un émetteur à distance dans lequel est indiquée la programmation desdits intervalles de temps.

2. Circuit amplificateur selon la revendication 1 à utiliser dans un émetteur d'une station mobile pouvant fonctionner dans un système de communication mobile et la station mobile comprenant un récepteur permettant de détecter ledit signal de commande provenant d'un émetteur-récepteur de base du système.

3. Circuit amplificateur selon l'une quelconque des revendications précédentes dans lequel le circuit de mesure comprend une boucle de commande à rétroaction qui permet de dériver un signal de commande d'erreur afin de permettre un réglage de polarisation de l'amplificateur de puissance.

4. Circuit amplificateur selon la revendication 3, le circuit comprenant un détecteur destiné à mesurer une propriété électrique d'une sortie de l'amplificateur de puissance et une boucle à rétroaction comprenant un comparateur destiné à comparer une sortie du détecteur à une valeur de référence prédéfinie afin de produire un signal de commande d'erreur.

5. Circuit amplificateur selon la revendication 4 dans lequel la boucle à rétroaction comprend, couplé à une sortie du comparateur, un processeur qui permet d'appliquer un algorithme afin de calculer à partir du signal de commande d'erreur provenant du comparateur un réglage de polarisation d'amplificateur nécessaire pour donner un signal d'erreur minimal sorti du comparateur.

6. Circuit amplificateur selon la revendication 5 dans lequel le processeur comprend un processeur de signal numérique et la boucle à rétroaction comprend, couplé à la sortie du processeur, un convertisseur numérique-analogique.

7. Circuit amplificateur selon la revendication 5 ou la revendication 6 dans lequel le processeur comprend un registre d'approximations successives.

8. Circuit amplificateur selon l'une quelconque des revendications 5 à 7 dans lequel le moyen de commande permet d'activer le circuit de mesure en réponse à la détection d'intervalles de temps prédéfinis et de désactiver le circuit de mesure pendant les périodes situées entre de tels intervalles de temps, et le processeur permet de fournir une sortie constante durant les périodes de désactivation du circuit de mesure.

9. Emetteur RF (31) comprenant un circuit amplificateur selon l'une quelconque des revendications précédentes.

10. Terminal à utiliser dans un système de communication RF, le terminal comprenant un émetteur selon la revendication 9 et un récepteur destiné à recevoir des signaux RF comprenant le signal de commande.

11. Terminal selon la revendication 10 et qui comprend une station mobile à utiliser dans un système de communication mobile.

12. Terminal selon la revendication 10 ou la revendication 11 et qui peut fonctionner selon les procédures standard TETRA.
